(19) Europäisches Patentamt / European Patent Office / Office européen des brevets

(11) **EP 2 889 915 A1**

(12) # EUROPEAN PATENT APPLICATION

(43) Date of publication:
**01.07.2015 Bulletin 2015/27**

(51) Int Cl.:
*H01L 29/78* (2006.01)     *H01L 29/06* (2006.01)

(21) Application number: **14163243.0**

(22) Date of filing: **02.04.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.12.2013 CH 21642013**

(71) Applicant: **ABB Technology AG**
**8050 Zürich (CH)**

(72) Inventor: **Bauer, Friedhelm**
**6714 Semione (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(54) **Power semiconductor device**

(57)     Disclosed is a semiconductor device comprising a semiconductor slab (1), in particular a semiconductor wafer or semiconductor die, said semiconductor slab (1) having a first main side (101) and a second main side (102), said second main side (102) being parallel to the first main side (101) at a distance with respect to a first direction; the semiconductor device further comprises a transistor cell, comprising a source electrode (431) formed on the first main side (101) and a drain electrode (41) formed on the second main side (102), the transistor cell further comprising between the first main side (101) and the second main side (102): a bulk layer (10) of a first conductivity type located between the first main side (101) and the second main side (102), and extending in the first direction between a distance $d_{b1}$ from the first main side (101) with $d_{b1} >= 0$ and a distance $d_{b2}$ from the first main side (101) with $d_{b2} > d_{b1}$, and in a second direction perpendicular to the first direction, a drain layer (2) of the first conductivity type, said drain layer being adjacent, preferably contiguous to the second main side (102), and electrically connected to the drain electrode (41), the transistor cell further comprising a base region (421, 421') of a second conductivity type, which is different from the first conductivity type, provided between the first main side (101) and the bulk layer (10), a source region (422, 422') of the first conductivity type, provided between the first main side and the base region, wherein the source electrode (431) is electrically connected to the source region (422, 422') and the base region (421, 421'), and a gate electrode (433, 433', 433") is arranged adjacent to the first main side (101), and electrically insulated from the source electrode (431), and wherein a floating region (11) of a second conductivity type is provided in the bulk layer (10) between a first distance $d_{f1}$ from the first main side (101) and a second distance $d_{f2}$ from the first main side (101).

Fig. 1

**Description**

*Field of invention*

The invention relates to the field of power electronics. In particular, it relates to a semiconductor device according to the preamble of claim 1.

*Background of the invention*

Over recent years, it has been found that wide bandgap power semiconductor devices in general and SiC power devices in particular allow for undisputed superiority in performance over power semiconductor devices based on Si. However, there remain severe reliability issues in particular for SiC power metal-oxide-semiconductor transistor (MOSFET) type power semiconductor devices. Most of them are related to an $SiO_2$ - SiC interface underneath a gate electrode, i.e. to an interface between an oxide ($SiO_2$) acting as insulator and a semiconductor slab in which a MOSFET cell is formed. When the MOSFET is in a blocking mode with a voltage equalling at least approximately a nominal blocking voltage applied between a drain and a source of the MOSFET, a bulk layer - frequently also referred to as drift layer throughout technical, scientific and patent literature - is at least almost completely depleted of charge carriers. As a consequence, a strong electric field builds up in the semiconductor slab in an area underneath the gate electrode, with peak values at an interface between bulk layer and a base region. According to Gauss' law, an electric field $E_{OX}$ in an oxide region immediately adjacent to the interface equals an electric field $E_{SC}$ in a semiconductor region immediately adjacent to the interface multiplied by an inverse ratio of the respective dielectric constants $\varepsilon$, exemplary values of which are $\varepsilon(SiO_2)$ = 3.9, $\varepsilon(SiC)$=9.7, and $\varepsilon(Si)$ = 11.9. While for a typical Si-based MOSFET in blocking mode, $E_{sc}(Si)$ is around $10^5$ V/cm, $E_{sc}(SiC)$ for a typical SiC-based MOSFET in blocking mode is around one order of magnitude larger, i.e. around $10^6$ V/cm due to a likewise larger breakdown voltage ($3.0 \cdot 10^5$ V/cm for Si vs. $2.5 \cdot 10^6$ V/cm for SiC). For the SiC-based MOSFET, the electric field $E_{ox}(SiC)$ in the oxide may thus reach peak values between 5 MV/cm and 6 MV/cm. At electric fields such strong, $SiO_2$ will become conducting (albeit at a low level compared to the semiconductor): a so-called charge to breakdown (injected charge before breakdown of the insulator layer) is reached in comparatively short time intervals, so that a lifetime expectancy of the semiconductor device will be unacceptable. Thus, very high electric field values in SiC, which are beneficial in other respects, negatively affect the field in insulators (increased field in gate oxide, passivation, etc.), possibly to a degree where a critical field strength for an onset of charge injection may be reached in normal operation. As most semiconductor device designs are likely to use some insulator at a place exposed to high electric fields, it is clear that not only MOSFETs are concerned, but also other wide bandgap semiconductor devices, e.g. junction field effect transistors (JFETs). Further, the effects as described above are particularly pronounced in trench MOSFETs, where particularly strong electric fields occur at a corner and/or bottom of a trench gate electrode.

It is an object of the invention to provide a power semiconductor device of the type mentioned initially which overcomes the problems described above.

*Description of the invention*

This object is achieved by a semiconductor device according to claim 1.

A semiconductor device in accordance with the present invention comprises a semiconductor slab, in particular a semiconductor wafer or semiconductor die, said semiconductor slab having a first main side and a second main side, said second main side being parallel to the first main side at a distance with respect to a first direction; the semiconductor device further comprises a transistor cell, comprising a source electrode formed on the first main side and a drain electrode formed on the second main side, the transistor cell further comprising between the first main side and the second main side: a bulk layer of a first conductivity type located between the first main side and the second main side, and extending in the first direction between a distance $d_{b1}$ from the first main side with $d_{b1} >= 0$ and a distance $d_{b2}$ from the first main side with $d_{b2} > d_{b1}$, and in a second direction perpendicular to the first direction, a drain layer of the first conductivity type, said drain layer being adjacent, preferably contiguous to the second main side, and electrically connected to the drain electrode, the transistor cell further comprising a base region of a second conductivity type, which is different from the first conductivity type, provided between the first main side and the bulk layer, a source region of the first conductivity type, provided between the first main side and the base region, wherein the source electrode is electrically connected to the source region and the base region, and a gate electrode is arranged adjacent to the first main side, and electrically insulated from the source electrode, and wherein a floating region of a second conductivity type is provided in the bulk layer between a first distance $d_{f1}$ from the first main side and a second distance $d_{f2}$ from the first main side.

The first distance $d_{f1}$ from the first main side is preferably chosen to fulfil $d_{f1} > 0$; however, in variations of the invention, $d_{f1} = 0$ may also advantageously be chosen. In particular, this may allow for simpler and more cost efficient manufacturing processes.

Further advantages according to the present invention will be apparent from the dependent claims.

**Brief description of the drawings**

The subject matter of the invention will be explained in more detail in the following text with reference to the attached drawings, in which:

FIG. 1 shows a sectional view of an individual, planar, metal-oxide-semiconductor field effect transistor cell as comprised by a first embodiment of a semiconductor device in accordance with the present invention,

FIG. 2 illustrates a prior art MOSFET cell design,

FIG. 3 shows plots of the electric field along line B-B' for the MOSFET cell design as shown in Fig. 2,

FIG. 4 shows results obtained by means of numerical simulation for the MOSFET cell design as shown in Fig. 1,

FIG. 5 shows a sectional view of an individual, planar, metal-oxide-semiconductor field effect transistor cell as comprised by a second embodiment of a semiconductor device in accordance with the present invention,

FIG. 6 Fig. 6 shows results obtained by means of numerical simulation for the MOSFET cell design similar to the one shown in Fig. 5,

FIG. 7 shows a sectional view of an individual, planar, metal-oxide-semiconductor field effect transistor cell as comprised by a third embodiment of a semiconductor device in accordance with the present invention,

FIG. 8 shows a sectional view of an individual, trench, metal-oxide-semiconductor field effect transistor cell as comprised by a fourth embodiment of a semiconductor device in accordance with the present invention,

FIG. 9 shows a sectional view of an individual junction field effect transistor (JFET) cell as comprised by a fifth embodiment of a semiconductor device in accordance with the present invention,

FIG. 10 schematically shows partial top views of cuts at $x_{float} = d_{float}$ parallel to the $y$-$z$-plane through various semiconductor devices in accordance with the present invention.

The reference signs used in the figures and their meaning are summarized in the list of reference signs. Generally, alike or alike-functioning parts are given the same reference signs. The described embodiments are meant as examples and shall not confine the invention.

**Detailed description of preferred embodiments**

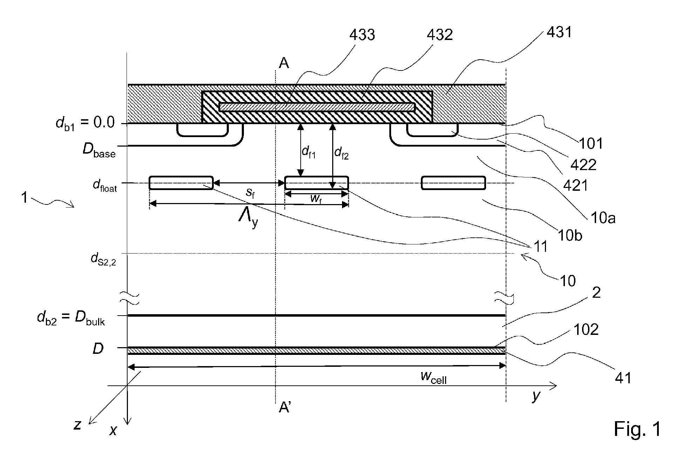

Fig. 1 shows a sectional view of an individual, planar, metal-oxide-semiconductor field effect transistor (MOSFET) cell as comprised by a first embodiment of a semiconductor device in accordance with the present invention. The transistor (MOSFET) cell is formed in and partially around a semiconductor slab 1, which was e.g. obtained from a SiC wafer through a plurality of process steps, generally including thinning, layer growing, implant and deposition and diffusion of dopants, and/or dicing. The semiconductor slab has a first main side 101 located at $x=0$ and a second main side 102, said second main side 102 being arranged parallel to the first main side 101 at a distance $D$ in ($x$)-direction, i.e. at $x = D$. A bulk layer 10 and an n-doped, preferably (n+)-doped, drain layer 2 are located between the first main side 101 and the second main side 102, and extend in a direction at least essentially parallel to the first and second main sides 101, 102 and parallel to one another.

The bulk layer 10 is (n-)-doped with an at least essentially homogeneous background doping concentration of $N_{bulk} = 4.0 \cdot 10^{15}$ cm$^{-3}$, and has a thickness $D_{bulk} = 40$ $\mu$m, the thickness being given as the maximum extension of the bulk layer in depth direction (i.e. x-direction). A drain electrode 41 is provided on the second main side, adjacent and contiguous to the drain layer 2, and with an ohmic contact formed between drain electrode 41 and drain layer 2. Source electrode 431 is provided on peripheral areas of the MOSFET cell contiguous to the first main side and; and also with ohmic contacts formed between source electrode 431 and semiconductor slab 1, in particular between the source electrode 431 and both source region 422 and p-doped base region 421. An insulator 432, preferably SiO$_2$, is formed on and contiguous to the first main side in a horizontal central area of the MOSFET cell. A gate electrode 433 is disposed over the semiconductor slab 1 in said horizontal central area of the MOSFET cell, and electrically insulated from semiconductor slab 1 by the insulator 432. A p-doped base region 421 having a thickness $D_{base} << D_{bulk}$ is formed between the first main side 101 and the bulk layer 10 at a peripheral area of the MOSFET cell, and adjacent to the first main side 101. An n-doped, preferably (n+)-doped, source region 422 is formed between the p-doped base region 421 and the first main side 101, and contiguous to the first main side 101. An upper side of the p-doped base region 421 is contiguous to the first main side outside of an area in which the n-doped source region 422 is formed.

A plurality of isolated, p-doped, preferably (p+)-doped, floating regions 11 having a net doping concentration $N_{float} > N_{bulk}$ are formed in the bulk layer 10 between a first distance $d_{f1}$ and a second distance $d_{f2}$ from the first main side 101, i.e. at a depth $x = d_{float}$ with $d_{float} := (d_{f2} - d_{f1})/2$, wherein preferably $0.5\,D_{base} < d_{float} \leq 20\,D_{base}$, most preferably $D_{base} < d_{float} \leq 10\,D_{base}$. In a vertical direction, the p-doped floating regions 11 have a thickness $D_f := d_{f2} - d_{f1}$ with $D_f << D_{bulk}$, preferably $D_f < D_{bulk}/10$, most preferably $D_f < D_{bulk}/100$. In a first horizontal direction, corresponding to a $y$-direction in Fig. 1, the p-doped floating regions 11 have a width $w_f$, typically in a range $0.5\ \mu m < w_f < 10\ \mu m$, preferably $5\ \mu m < w_f < 8\ \mu m$. The width is the maximum extension of the floating regions 11 in a direction parallel to the first main side 101 (e.g. in y-direction). Neighboring p-doped floating regions 11 are spaced apart from one another with respect to the $y$-direction with a spacing $s_f$ typically in a range $1\ \mu m < s_f < 10\ \mu m$, preferably $2\ \mu m < s_f < 6\ \mu m$ and preferably $3\ \mu m < s_f < 4\ \mu m$.

An actual MOSFET-type semiconductor device comprises a plurality, typically several hundred to a few thousands, of individual MOSFET cells as shown in Fig. 1, arranged contiguous to one another in y-direction, each cell having a width $w_{rell}$ typically in a range $5\ \mu m < w_{cell} < 60\ \mu m$, preferably $10\ \mu m < w_{cell} < 25\ \mu m$. The laterally contiguous bulk layers 10 of the individual MOSFET cells thus form a contiguous bulk layer in the MOSFET-type semiconductor device. Likewise, the p-doped floating regions 11 form a buried grid with a period $\Lambda_y = w_f + s_f$ within the contiguous bulk layer of the MOSFET -type semiconductor device.

The buried grid of p-doped floating regions 11 may be regarded as a floating sublayer which is located within the contiguous bulk layer 10 of the actual MOSFET-type semiconductor device, and which separates a first bulk sublayer 10a located above the buried grid of p-doped floating regions 11, i.e. between $x = d_{b1}$ and $x = d_{float}$, in particular between $x = d_{b1}$ and $x = d_{f1}$, from a second bulk sublayer 10b located below the buried grid of p-doped floating regions 11, i.e. between $x = d_{float}$ and $x = d_{b2}$, in particular between $x = d_{f2}$ and $x = d_{b2}$. A doping concentration $N_{bulk1}$ of the first bulk sublayer 10a is preferably chosen identical to a doping concentration $N_{bulk2}$ of the second bulk sublayer 10b at $N_{bulk1} = N_{bulk2} = N_{bulk}$.

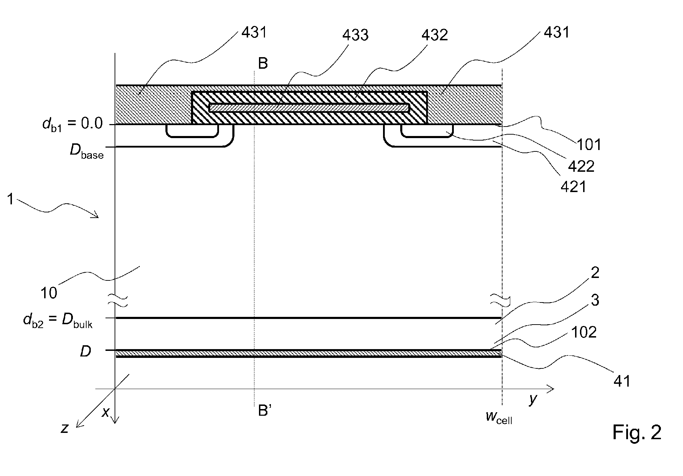

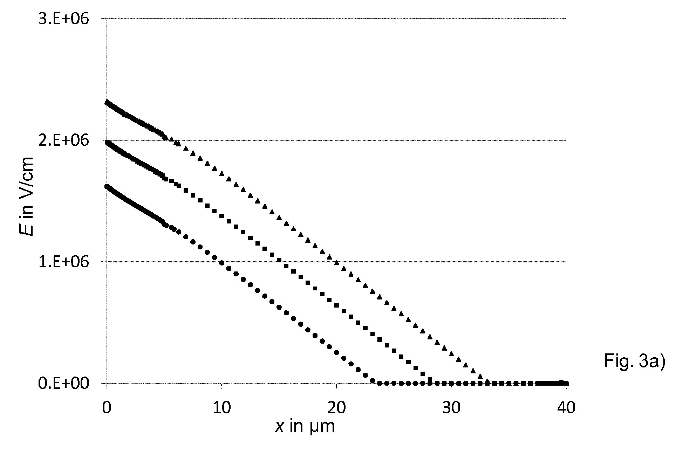

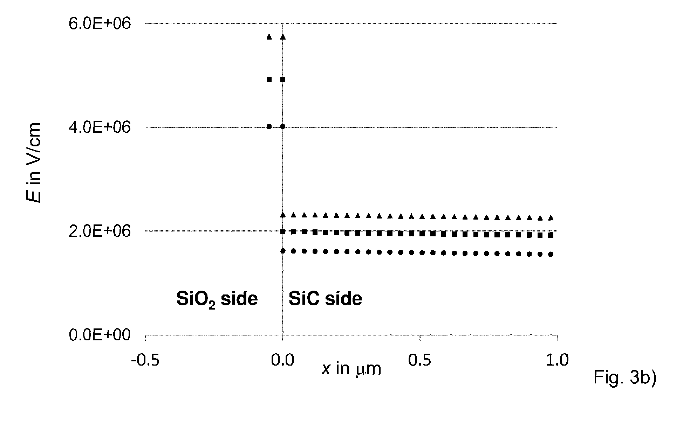

Numerical simulations were carried out to illustrate the benefits of the MOSFET cell design according to Fig. 1. For comparison, a prior art MOSFET cell design as shown in Fig. 2 was considered for reference first. This prior art MOSFET cell design is identical to the one shown in Fig. 1, albeit for the absence of p-doped floating regions 11. MOSFET-type semiconductor devices based on such prior art cell design reach a breakdown voltage $V_{br}$ in excess of 4000 V; at an on-state resistance at T = 400 K of 25 mΩcm. The cell design would be suitable for a MOSFET-type semiconductor device in the 3.3 kV class. Fig. 3a shows plots of the electric field along line B-B' for the MOSFET cell design as shown in Fig. 2 with $w_{cell} = 20\ \mu m$ and $D_{base} = 0.5\ \mu m$ in blocking mode. The circular markers represent electric field values for a voltage $V_{ce} = 2000$ V between drain electrode 41 and source electrode 431; the quadratic markers for $V_{ce} = 3000$ V. The triangular markers represent electric field values at a breakdown voltage $V_{br}$. Fig. 3b) shows an enlargement from Fig. 3a) in a vicinity of the SiO2 - SiC interface. Fig. 3 confirms the problems discussed above in the introduction.

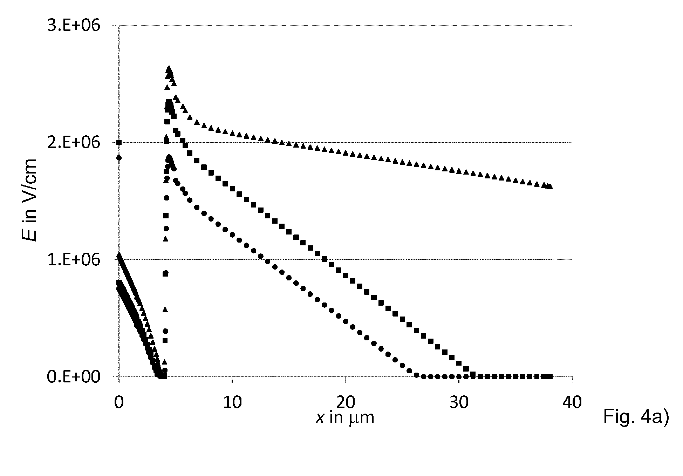

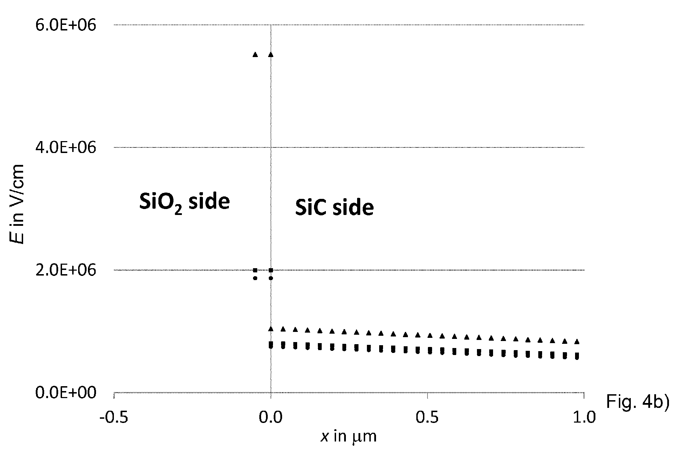

Fig. 4 shows results obtained by means of numerical simulation for the MOSFET cell design as shown in Fig. 1 with $w_f = 3.0\ \mu m$, and $s_f = 2.0\ \mu m$. The buried grid of p-doped floating regions is arranged at at $x = d_{float} = 4.0\ \mu m$ in close vicinity of a main blocking junction of the MOSFET cell. For the MOSFET cell design discussed here, this is a junction between p-doped base region 421 and (n-)-doped bulk layer 10. Fig. 4a shows plots of the electric field along line A-A' in blocking mode. The circular markers again represent electric field values for a blocked voltage $V_{ce} = 2000$ V between drain electrode 41 and source electrode 431; the quadratic markers for $V_{ce} = 3000$ V. The triangular markers represent electric field values at a breakdown voltage $V_{br}$. Fig. 4b) shows an enlargement from Fig. 4a) in a vicinity of the SiO2 - SiC interface. As the simulation results indicate, electric field $E_{sc}$ is reduced within the first bulk sublayer 10a as compared to the prior art MOSFET cell design even at high blocked voltages.

The numerical simulation results as illustrated in Fig. 4 show that for blocked voltages of 2 kV and 3 kV, the MOSFET cell design according to Fig. 1 allows for a reduction in electric field $E_{ox}$ down to about 2 MV/cm as compared to between 4 MV/cm to 5 MV/cm for the prior art MOSFET cell design as shown in Fig. 2. The corresponding electric field $E_{sc}$ in a semiconductor region immediately adjacent to the SiC-SiO$_2$ interface was reduced from about 2 MV/cm to around 800 kV/cm. Note that the electric field values at breakdown voltage $V_{br}$ in Fig. 4 were obtained assuming heavy impact ionization conditions (high current). These conditions cause a modification of an effective doping concentration (impact ionization) of the bulk layer and are expressed in a different slope of the electric field plot.

The reduction of the electric field $E_{sc}$ as described above, however, is synonymous with a reduction of the blocking capability, i.e. in breakdown voltage $V_{br}$. To keep this reduction as small as possible, the buried grid of p-doped floating regions 11 is advantageously placed as closely as possible to the main blocking junction, and thus to the interface to be protected from high electric field values: Additional MOSFET cell designs were investigated where the buried grid of p-doped floating regions 11 was located at $x = d_{\text{float}}$ = 3.0 μm and $x = d_{\text{float}}$ = 2.0 μm, respectively. They also showed a reduced surface electric field, but less pronounced reduction in breakdown voltage $V_{\text{br}}$ as compared to the prior art MOSFET cell design.

Preferably, in embodiments as described above and below, the doping concentration $N_{\text{bulk1}}$ of the first bulk sublayer 10a may be deliberately chosen different from, in particular larger than, the doping concentration $N_{\text{bulk2}}$ of the second bulk sublayer 10b to limit a value of the electric field $E_{\text{ox}}$ in the oxide in the vicinity of the $SiO_2$ - SiC interface to a given value $E_{ox}^{\max}$ in line with reliability requirements for the semiconductor device and/or an envisaged application. According to Gauss' law, the electric field $E_{\text{ox}}$ for the power MOSFET cell as shown in Fig. 1 may then be expressed as

$$E_{ox} = \frac{q \bullet N_{bulk1} \bullet D_{bulk1}}{\varepsilon_{SiO_2}}$$

with q being the electric charge in C. If, for example, the oxide field $E_{\text{ox}}$ shall not exceed a value of $E_{ox}^{\max}$ = 2.0 MV/cm, then this requirement can be met by a doping concentration $N_{\text{bulk1}}$ within the first bulk sublayer 10a with

$$N_{bulk1} \bullet D_{bulk1} = \frac{\varepsilon_{SiO_2} \bullet E_{ox}^{\max}}{q} \, .$$

When depleted, the first bulk sublayer 10a of the MOSFET cell design as shown in Fig. 1 may accommodate a blocking voltage of

$$V_{bulk1} = \frac{\varepsilon_{SiO_2} \bullet D_{bulk1} \bullet E_{ox}^{\max}}{2 \bullet \varepsilon_{SiC}} \, .$$

In comparison, for the prior art MOSFET cell design as shown in Fig. 2, a region of the bulk layer 10 immediately adjacent to the SiC-$SiO_2$ interface of corresponding thickness $D_{\text{bulk1}}$ will be able to accommodate a voltage $V_{\text{ref}}$

$$V_{ref} = \frac{D_{bulk1}}{2} \bullet \left( \frac{2 \bullet \varepsilon_{SiO_2}}{\varepsilon_{SiC}} \bullet E_{ox} - \frac{q \bullet N_{bulk} D_{bulk1}}{\varepsilon_{SiC}} \right) \, .$$

A reduction in breakdown voltage $V_{\text{diff}} = V_{\text{ref}} - V_{\text{bulk1}}$ is thus given by

$$V_{diff} = \frac{D_{bulk1}}{2} \bullet \left( \frac{2 \bullet \varepsilon_{SiO_2}}{\varepsilon_{SiC}} \bullet E_{ox} - \frac{q \bullet N_{bulk0} \bullet W_{top}}{\varepsilon_{SiC}} \right) - \frac{\varepsilon_{SiO_2} \bullet D_{bulk1} \bullet E_{ox}^{\max}}{2 \bullet \varepsilon_{SiC}} =$$

$$= \frac{\varepsilon_{SiO_2} \bullet D_{bulk1}}{\varepsilon_{SiC}} \bullet \left( E_{ox} - \frac{E_{ox}^{red}}{2} - \frac{q \bullet N_{bulk0}}{2 \bullet \varepsilon_{SiO_2}} \right)$$

The reduction of the breakdown voltage $V_{\text{diff}}$ is mainly governed by the thickness $D_{\text{bulk1}}$ of the first bulk sublayer 10a as detailed above and by the reduction of the electric field $E_{\text{ox}}$. To minimize this loss, the first bulk sublayer 10a should be as thin as possible. The results of the numerical simulations indicate a reduction of the breakdown voltage $V_{\text{br}}$ of about

400 V (i.e. by approximately 10 %) for the MOSFET cell design in accordance with the present invention as shown in Fig. 1 as compared to the prior art MOSFET cell design as shown in Fig. 2. This result is in line with calculated results for $V_{diff}$ according to the simple analytical model as presented above. This small loss in $V_{br}$ may be easily recovered by adaptation of the doping concentration of the bulk layer.

By advantageously choosing the doping concentration $N_{bulk1}$ of the first bulk sublayer 10a larger than, the doping concentration $N_{bulk2}$ of the second bulk sublayer 10b, a potential disadvantage of the MOSFET cell design in accordance with the present invention as shown in Fig. 1 may be mitigated: As numerical simulations have revealed, the p-doped floating regions 11 become virtually non-transparent for electrons at doping concentrations of $N_{float} \geq 1.0 \cdot 10^{18} cm^{-3}$. This leads to a so called current encroachment which in turn results in an increase of an effective resistance of the bulk layer 10 by about 10 or 20 %. Choosing e.g. $N_{bulk1} = 1.0 \cdot 10^{16}$ cm$^{-3}$ and $N_{bulk2} = 4.0 \cdot 10^{15}$ cm$^{-3}$ in the above embodiments allows to completely compensate for the current encroachment.

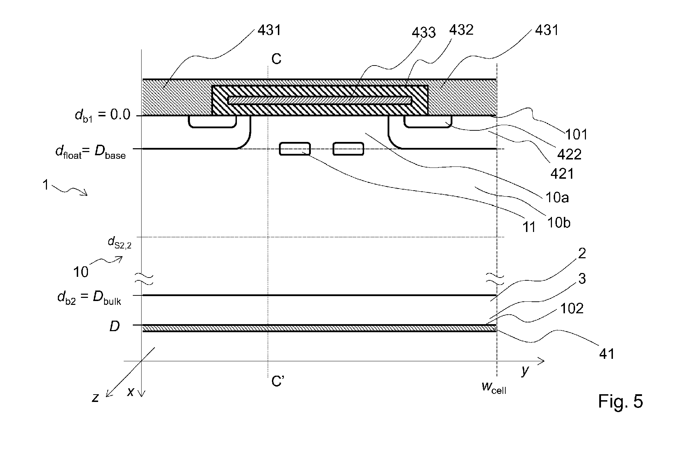

Fig. 5 shows a sectional view of an individual, planar, metal-oxide-semiconductor field effect transistor cell as comprised by a second embodiment of a semiconductor device in accordance with the present invention. The metal-oxide-semiconductor field effect transistor cell of this second embodiment is identical to the one according to the first embodiment shown in Fig. 1 but for the location of the p-doped floating regions 11, which is laterally restricted to an area below the gate electrode 433. In particular, no p-doped floating regions 11 are present below the p-doped base region 421. The p-doped base region 421 may thus fully assume its task of a main blocking junction together with the p-doped floating regions 11 to keep electric fields low in a vicinity of the SiO$_2$ - SiC interface. In the second embodiment as shown in Fig. 5, the p-doped floating regions 11 are located at a depth of $x = d_{float} = D_{base} = 1 .0 \ \mu m$. However, the p-doped floating regions 11 could advantageously be placed at both smaller or larger depths. In particular, $d_{f1} < D_{base}$, may be chosen, preferably in combination with $d_{f2} < D_{base}$. Prefereably, $d_{f1} = d_{b1}$, in particular $d_{f1} = 0$, may also be chosen, preferably again in combination with $d_{f2} < D_{base}$. For a choice of $d_{f1} = d_{b1}$, in particular $d_{f1} = 0$, the grid of p-doped floating regions 11 becomes effectively a surface grid and contigous to insulator 432, which allows for significant simplifications of a manufacturing process for the semiconductor device, and thus substantial cost reductions.

A manufacturing process for the the semiconductor element according to second embodiment as just described may be substantially simplified as compared to a manufacturing process the first embodimentdescribed further above, which generally requires a two-step epitaxial process with an interruption between the steps. For manufacturing a semiconductor element according to first embodiment, after growth of the second bulk sublayer 10b, the p-doped floating regions 11 are generally created by ion implantation making use of a photolithographic step and by masking of areas where no p-doped floating regions 11 are desired. After cleaning, the first bulk sublayer 10a is formed by means of epitaxy, preferably with enhanced doping concentration $N_{bulk1} > N_{bulk2}$. For manufacturing a semiconductor element according to second embodiment, in contrast, the whole bulk layer 10 may be grown in a single process step (as during manufacturing of a conventional SiC power MOSFET). Enhanced doping concentration $N_{bulk1} > N_{bulk2}$ for for bulk layer locations $x < x_{enh}$, preferably within the prospective first bulk sublayer 10a, i.e. with $d_{f2} > x_{enh} > d_{b1}$, can be accomplished without interruption of the epitaxy process. Only afterwards, the p-doped floating regions 11 may be created, preferably at $d_{float} = x_{float} = x_{enh}$, by conventional ion implantation after formation of the p-doped base region 421, wherein increased implant energies may be required. Alternatively, the p-doped floating regions 11 may also be created at $d_{float} < x_{enh}$, preferably $d_{f2} < x_{enh}$.

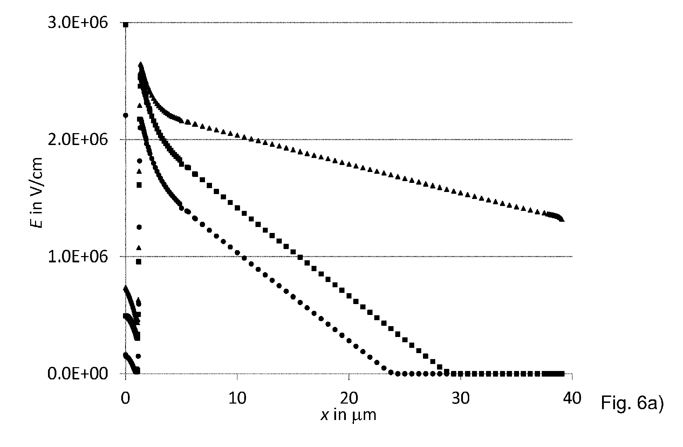

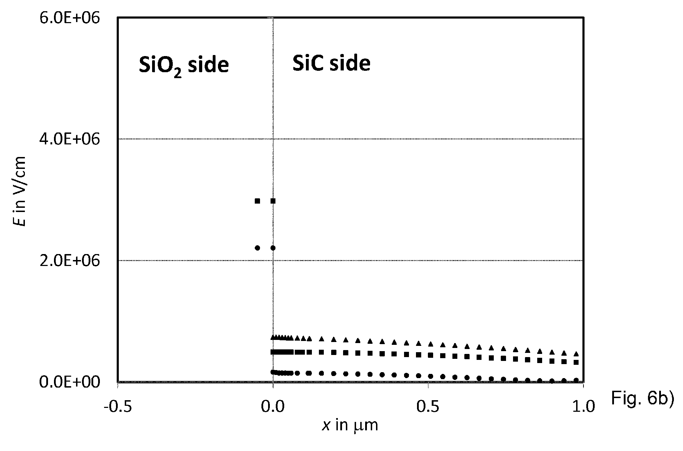

Fig. 6 shows results obtained by means of numerical simulation for the MOSFET cell design similar to the one shown in Fig. 5, albeit with a single p-doped floating region of width $w_f = 3.0 \ \mu m$ arranged at $x = d_{float} = 1.0 \ \mu m$. Fig. 6a) shows plots of the electric field along line C-C' in blocking mode. The circular markers again represent electric field values for a voltage $V_{ce} = 2000$ V between drain electrode 41 and source electrode 431; the quadratic markers for $V_{ce} = 3000$ V. The triangular markers represent electric field values at breakdown voltage $V_{br}$. Fig. 6b) shows an enlargement from Fig. 6a) in a vicinity of the SiO2 - SiC interface. As the simulation results indicate again, within a thin area of the semiconductor slab 1 between the buried grid of p-doped floating regions 11 and the first main side 101, electric field is reduced as compared to the prior art MOSFET cell design even at high blocked voltages, which again leads to a reduction of the blocking capability. However, when comparing the first and the second embodiment by means of numerical simulation, it was found that the loss in breakdown voltage can be further reduced for the second embodiment. Its breakdown voltage is merely 4 % lower than that for the prior art MOSFET cell, at unchanged on-state resistance. This is mainly due to the continued thinning of the first bulk sublayer 10a down to 1.0 $\mu m$.

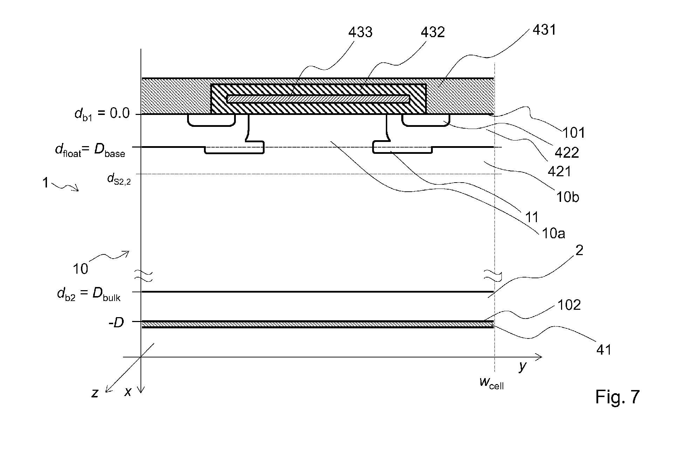

Fig. 7 shows a sectional view of an individual planar metal-oxide-semiconductor field effect transistor cell as comprised by a third embodiment of a semiconductor device in accordance with the present invention. In this third embodiment as shown in Fig. 5, p-doped floating regions 11 are again located at a depth of $x = d_{float} = D_{base} = 1 .0 \ \mu m$, but intersect with the the p-doped base region 421.

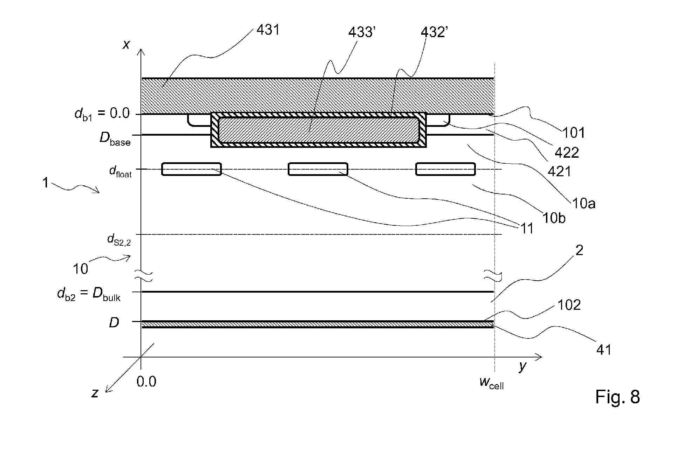

Fig. 8 shows a sectional view of an individual trench metal-oxide-semiconductor field effect transistor cell as comprised by a fourth embodiment of a semiconductor device in accordance with the present invention.

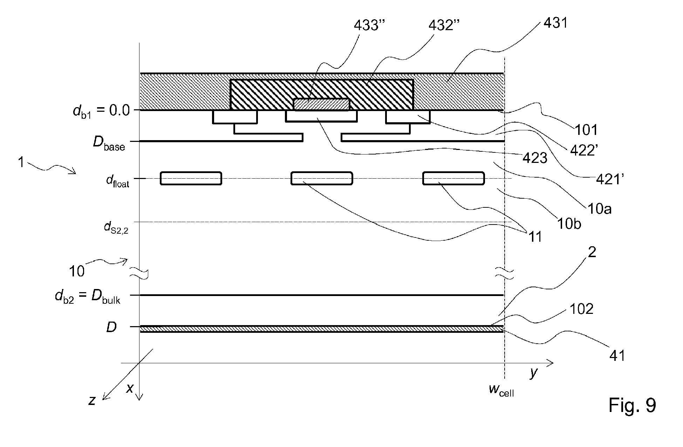

Fig. 9 shows a sectional view of an individual junction field effect transistor (JFET) cell as comprised by a fifth embodiment of a semiconductor device in accordance with the present invention. The JFET cell again comprises a semiconductor slab 1, which was e.g. obtained from a SiC wafer through a plurality of process steps, generally including thinning, layer growing, implant and deposition and diffusion of dopants, and/or dicing. The semiconductor slab 1 has a first main side 101 located at $x=0$ and a second main side 102, said second main side 102 being arranged parallel to the first main side 101 at a distance $D$ in $(x)$-direction, i.e. at $x = D$. Again, a bulk layer 10 and an n-doped, preferably (n+)-doped, drain layer 2 are located between the first main side 101 and the second main side 102, and extend in a direction at least essentially parallel to the first and second main sides 101, 102 and parallel to one another. The bulk layer 10 is (n-)-doped with an at least essentially homogeneous background doping concentration of $N_{bulk}$. A drain electrode 41 is provided on the second main side 102, adjacent and contiguous to the drain layer 2, and with an ohmic contact formed between drain electrode 41 and drain layer 2. A source electrode 431 is provided on a laterally peripheral area of the JFET cell contiguous to the first main side 101; and also with an ohmic contact formed between source electrode 431 and semiconductor slab 1. A p-doped base region 421" having a thickness $D_{base} \ll D_{bulk}$ is formed between the first main side 101 and the bulk layer 10 at a laterally peripheral area of the JFET cell, and adjacent to the first main side 101. An n-doped, preferably (n+)-doped, source region 422" is formed contiguous to the first main side in an area between the base regions 421', the first main side 101, and the bulk layer 10. A p-doped gate region 423 is formed between the first main side 101 and the bulk layer 10 in a laterally central area of the JFET cell, and contiguous to the first main side, with the bulk layer 10 separating the gate region 423 from the base region 421', the source region 422', and the drain layer 2. A gate electrode 433" is disposed over said laterally central area of the JFET cell, contiguous to the first main side 101, and electrically connected to the gate region 423. The gate electrode 433" is electrically isolated from the source electrode 431 by an insulator 432".

Preferably, in embodiments as described above and below, a thickness of the second bulk sublayer 10b may also be limited by $x = d_{S2,2}$; in particular with doping concentrations chosen according to $N_{bulk1} > N_{bulk2} > N_{bulk}$, wherein $N_{bulk}$ is the doping concentration of the remaining portion of the bulk layer within a vertical region given by $d_{S2,2} > x > d_{b2}$.

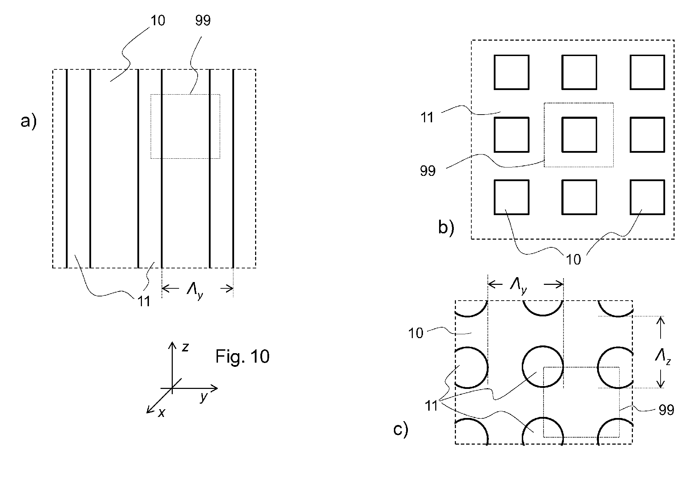

Preferably, in all embodiments as described above, the p-doped, preferably (p+)-doped, floating regions 11 extend continuously and/or uniformly in a second horizontal direction represented by the positive z-direction of Fig. 1, 2, 5, 7 and 8, said second horizontal direction corresponding to a third spatial dimension of the semiconductor device. The p-doped floating regions 11 thus form parallel stripes into the third dimension. Alternatively, p-doped, preferably (p+)-doped, floating regions 11 may also form a grid in the third dimension, preferably periodic in z-direction with a period of $\Lambda_z$. Fig. 10 schematically shows partial top views of cuts at $x = d_{float}$ parallel to the $y$-$z$-plane through various semiconductor devices in accordance with the present invention, having different, exemplary p-doped floating region layouts. Examplary cell boundaries of semiconductor device cells, in particular MOSFET cells or JFET cells, are indicated by rectangle 99.

Preferably, in embodiments as described above and below, the conductivity types may be interchanged, i.e. all (n-)-, n-, or (n+)-layers and regions as described may be replaced by (p-)-, p-, or (p+)-layers and regions, respectively, and vice versa.

Unless stated otherwise, all doping concentrations $N$ referred to in this patent application are net doping concentrations, where $N$ is defined as $N := N_D - N_A$ for regions or layers in which a total density of donors $N_D$ is larger than a total density of acceptors $N_A$, i.e. $N_D > N_A$, i.e. in particular for n-doped regions or layers; and as $N := N_A - N_D$ for regions or layers in which a total density of donors $N_D$ is smaller than a total density of acceptors $N_A$, i.e. in particular for p-doped regions or layers. Preferably, in embodiments as described above, suffixes "-" and "+" after doping type indicators p, n are used to express relative net doping concentrations. In particular, a net doping concentration $N(n+)$ of each (n+)-doped region or layer is larger than a net doping concentration $N(n)$ of each (n)-doped region or layer, which in turn is larger is larger than a net doping concentration $N(n-)$ of each (n-)-doped region or layer. Likewise, a net doping concentration $N(p+)$ of each (p+)-doped region or layer is larger than a net doping concentration $N(p)$ of each (p)-doped region or layer, which in turn is larger than a net doping concentration $N(p-)$ of each (p-)-doped region or layer. Preferably, $N(n+) \geq N(p)$, $N(n) \geq N(p-)$, $N(p+) \geq N(n)$ and/or $N(p) \geq N(n-)$; most preferably, $N(n+) > N(p)$, $N(n) > N(p-)$, $N(p+) > N(n)$ and/or $N(p) > N(n-)$ also hold. On the other hand, where identical suffixes are used with regard to different layers or regions, this shall preferably not be construed to imply that the doping concentrations of said different layers or regions are identical.

Preferably, in embodiments as described above and below, where a doping concentration or net doping concentration of a region or layer is referred to, this is preferably to be understood as a maximum net doping concentration within said region or layer. In particular for doped regions or layers which were formed including a dopant diffusion process step, a local net doping concentration decays in one or more spatial directions from an area within the region or layer, in which area the local doping concentration equals the maximum net doping concentration.

Preferably, in embodiments as described above and below, bulk layer 10, and preferably the bulk sublayers 10a and 10b, are layers having net doping concentration unamended by any dopant diffusion process step, i.e. having the net doping concentration as achieved preferably by epitaxial growth of the bulk layer 10, and preferably the bulk sublayers 10a and 10b. Exemplarily, the bulk layer 10 has a constantly low net doping concentration $N_{bulk}$. Therein, the substantially constant net doping concentration of the bulk layer 10 means that the net doping concentration is substantially homogeneous throughout the bulk layer 10, however without excluding that fluctuations in the net doping concentration within the bulk layer 10 being in the order of a factor of one to five may possibly be present due to e.g. fluctuations in the epitaxial growth process. The final bulk layer thickness and net doping concentration is chosen due to the application needs.

If a region or layer is referred to as being formed or as being provided in the bulk layer (or any other comprising layer or region), it is understood that within the former region or layer the physical properties, in particular the doping type and concentration, of said former region or layer prevail over the properties, in particular the doping type and concentration, of the bulk layer (or the other comprising layer or region as referred to above). On the other hand, when the physical properties, in particular the doping type and concentration, of the bulk layer (or the other comprising layer or region as referred to above) are referred to, physical properties, in particular the doping type and concentration, of the regions or layers formed in the latter or provided in the latter are not taken into account.

Preferably, in embodiments as described above and below, other wide bandgap semiconductor materials, in particular AIN, GaN, or BN may be used for the semiconductor slab 1. Alternatively, Si may also be used for the semiconductor slab 1, albeit with all vertical dimensions as specified above and below preferably increased by a factor of greater than 5, most preferably greater than 10.

In embodiments as described above, the term "vertical" refers to a vertical direction represented by the positive $x$-direction in the Figures and corresponding to a first spatial dimension of the semiconductor device perpendicular to the first main side 101. In particular, unless otherwise stated, terms "up", "down", "top", "bottom", "above", "below", "underneath", "depth", "thickness", etc. refer to an orientation, extension, dimension, distance, (relative) location etc. with respect to the vertical direction. Likewise, the term "lateral" refers to a first horizontal direction, perpendicular to the vertical direction, represented by the positive $y$-direction in the Figures, and corresponding to a second spatial dimension of the semiconductor device, parallel to the first main side 101. In particular, unless otherwise stated, the term "width" refers to an extension, dimension, distance, etc. in the first horizontal direction.

Unless stated otherwise, it is assumed that throughout this patent application, a statement $a \approx b$ implies that $|a\text{-}b|/(|a|+|b|) < 1/10$, preferably $|a\text{-}b|/(|a|+|b|) < 1/100$, wherein $a$ and $b$ may represent arbitrary variables as described and/or defined anywhere in this patent application, or as otherwise known to a person skilled in the art. Further, a statement that $a$ is at least approximately equal or at least approximately identical to $b$ implies that $a \approx b$, preferably $a = b$. Further, unless stated otherwise, it is assumed that throughout this patent application, a statement $a >> b$ implies that $a > 10b$, preferably $a > 100b$; and statement $a << b$ implies that $10a < b$, preferably $100a < b$.

It should be noted that the term "comprising" does not exclude other features, in particular elements or steps, and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

***List of Reference Signs***

| | |
|---|---|
| 1 | semiconductor slab |
| 10 | bulk layer |
| 10a | first bulk sublayer |
| 10b | second bulk sublayer |
| 101 | first main side |
| 102 | second main side |
| 11 | p-doped floating region |
| 2 | drain layer |
| 41 | drain electrode |
| 421 | base region |
| 422 | source region |
| 423 | gate region |
| 431 | source electrode |
| 432, 432', 432" | insulator |
| 433, 433" | planar gate electrode |

433'           trench gate electrode
99             Exemplary semiconductor cell boundaries

**Claims**

1. A semiconductor device comprising

   a) a semiconductor slab (1), in particular a semiconductor wafer or semiconductor die, the semiconductor slab (1)

   i) having a first main side (101) and a second main side (102), said second main side (102) being parallel to the first main side (101) at a distance with respect to a first direction; the semiconductor device further comprising

   ii) a transistor cell, comprising a source electrode (431) formed on the first main side (101) and a drain electrode (41) formed on the second main side (102), the transistor cell further comprising between the first main side (101) and the second main side (102):

   iii) a bulk layer (10) of a first conductivity type located between the first main side (101) and the second main side (102), and extending in the first direction between a distance $d_{b1}$ from the first main side (101) with $d_{b1} >= 0$ and a distance $d_{b2}$ from the first main side (101) with $d_{b2} > d_{b1}$, and in a second direction perpendicular to the first direction,

   iv) a drain layer (2) of the first conductivity type, said drain layer being adjacent, preferably contiguous to the second main side (102), and electrically connected to the drain electrode (41),

   the transistor cell further comprising

   i) a base region (421, 421') of a second conductivity type, which is different from the first conductivity type, provided between the first main side (101) and the bulk layer (10),

   ii) a source region (422, 422') of the first conductivity type, provided between the first main side and the base region,

   b) wherein the source electrode (431) is electrically connected to the source region (422, 422') and the base region (421, 421'), and

   c) a gate electrode (433, 433', 433") is arranged adjacent to the first main side (101), and electrically insulated from the source electrode (431),

   **characterized in that**

   d) a floating region (11) of the second conductivity type is provided in the bulk layer (10) between a first distance $d_{f1}$ from the first main side (101) and a second distance $d_{f2}$ from the first main side (101).

2. The semiconductor device according to claim 1, **characterized in that** plurality of, preferably at least 4, floating regions (11) of the second conductivity type are provided in the bulk layer (10) between the first distance $d_{f1}$ from the first main side (101) and the second distance $d_{f2}$ from the first main side (101), said floating regions (11) being spaced apart from one another with respect to the second direction.

3. The semiconductor device according to one of the previous claims, **characterized in that** the floating regions (11) are located at a depth $d_{float} = (d_{f2} - d_{f1})/2$ from the first main side (101), with $10 d_{float} < D_{bulk}$, preferably $30\ d_{float} < D_{bulk}$, wherein $D_{bulk} = d_{b2} - d_{b1}$ is a thickness of the bulk layer.

4. The semiconductor device according to one of the previous claims, **characterized in that** the floating regions (11) are located at a depth $d_{float} = (d_{f2} - d_{f1})/2$ from the first main side (101), with $10\ \mu m > d_{float} > 0.5\ \mu m$, preferably $5 \mu m > d_{float} > 1.0\ \mu m$.

5. The semiconductor device according to one of the previous claims, **characterized in that** a thickness $D_{float} = d_{f2} - d_{f1}$ of the floating regions (11) is smaller than a thickness $D_{bulk} = d_{b2} - d_{b1}$ of the bulk layer (10), i.e. $30\ D_{float} < D_{bulk}$, preferably $100\ D_{float} < D_{bulk}$; and/or **in that** $D_{float} < 5\ \mu m$, preferably $D_{float} < 2\ \mu m$.

6. The semiconductor device according to one of the previous claims, **characterized in that** the doping concentration $N_{float}$ of the floating regions (11) is between $10^{17}$ cm$^{-3}$ and $5.0 \cdot 10^{20}$ cm$^{-3}$, preferably between $1.0 \cdot 10^{19}$ cm$^{-3}$ and $2.0.10^{20}$ cm$^{-3}$.

7. The semiconductor device according to one of the previous claims, **characterized in that** the floating regions (11) have a width $w_f$ of 4 $\mu$m < $w_f$ < 8 $\mu$m, preferably 6 $\mu$m < $w_f$ < 7 $\mu$m in the second direction.

8. The semiconductor device according to one of the previous claims, **characterized in that** for a spacing $s_f$ in the second direction between floating regions (11), 2 $\mu$m < $s_f$ < 6 $\mu$m, preferably 3 $\mu$m < $s_f$ < 4 $\mu$m.

9. The semiconductor device according to one of the previous claims, **characterized in that** the transistor cell is a planar metal-oxide-silicon transistor cell, wherein the gate electrode (433) is electrically insulated from the semiconductor slab (1).

10. The semiconductor device according to one of the previous claims, **characterized in that** the transistor cell is a trench metal-oxide-silicon transistor cell, wherein the gate electrode (433) is electrically insulated from the semiconductor slab (1).

11. The semiconductor device according to one of the claims 1 through 8, **characterized in that** the transistor cell is a junction-field-effect transistor cell, wherein

    a) a gate region (423) of the first conductivity type is provided between the first main side (101) and the bulk layer (10), and adjacent to the first main side (101),
    b) the gate electrode (433") is contiguous to the first main side (101and
    c) wherein the gate electrode (433") is electrically connected to the gate region (423).

Fig. 1

Fig. 2

Fig. 3a)

Fig. 3b)

Fig. 4a)

Fig. 4b)

Fig. 5

Fig. 6a)

Fig. 6b)

Fig. 7

Fig. 8

Fig. 9

a)

10    99

11    $\Lambda_y$

z
y
x

Fig. 10

b)

11

99

10

c)

$\Lambda_y$

10

$\Lambda_z$

11

99

Europäisches
Patentamt

European
Patent Office

Office européen
des brevets

## EUROPEAN SEARCH REPORT

Application Number

EP 14 16 3243

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 198 03 424 C1 (SIEMENS AG [DE]) 2 June 1999 (1999-06-02) * the whole document * | 1,2,4-10 | INV. H01L29/78 H01L29/06 |
| X | JP H11 87698 A (KANSAI ELECTRIC POWER CO; HITACHI LTD) 30 March 1999 (1999-03-30) * abstract; figure 4 * * paragraph [0014] * * paragraph [0016] * * paragraph [0021] * | 1-6,8,10 | |
| X | DE 198 30 332 A1 (SIEMENS AG [DE] INFINEON TECHNOLOGIES AG [DE]) 20 January 2000 (2000-01-20) * column 2, line 35 - line 67; figure 1 * * column 3, line 2 - line 4 * | 1,2,9,11 | |
| X | EP 2 626 905 A2 (SUMITOMO ELECTRIC INDUSTRIES [JP]) 14 August 2013 (2013-08-14) * paragraph [0021] - paragraph [0033]; figure 1 * * paragraph [0067] - paragraph [0073]; figure 23 * | 1,2,9,10 | TECHNICAL FIELDS SEARCHED (IPC) H01L |
| X | DE 10 2010 063314 A1 (BOSCH GMBH ROBERT [DE]) 21 June 2012 (2012-06-21) * paragraph [0014] - paragraph [0017]; figures 3,4 * | 1,2,10 | |
| A | WO 99/26296 A2 (ABB RESEARCH LTD [CH]; BIJLENGA BO [SE]; ZDANSKY LENNART [SE]; HARRIS) 27 May 1999 (1999-05-27) * the whole document * | 1-9 | |

The present search report has been drawn up for all claims

| Place of search | Date of completion of the search | Examiner |
|---|---|---|
| Munich | 29 July 2014 | Lantier, Roberta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 14 16 3243

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2014

| Patent document cited in search report | | Publication date | Patent family member(s) | | Publication date |
|---|---|---|---|---|---|
| DE 19803424 | C1 | 02-06-1999 | DE | 19803424 C1 | 02-06-1999 |
|  |  |  | WO | 9939388 A1 | 05-08-1999 |
| JP H1187698 | A | 30-03-1999 | NONE | | |
| DE 19830332 | A1 | 20-01-2000 | DE | 19830332 A1 | 20-01-2000 |
|  |  |  | EP | 1095408 A1 | 02-05-2001 |
|  |  |  | JP | 2002520816 A | 09-07-2002 |
|  |  |  | US | 2001020732 A1 | 13-09-2001 |
|  |  |  | WO | 0002250 A1 | 13-01-2000 |
| EP 2626905 | A2 | 14-08-2013 | CN | 103247680 A | 14-08-2013 |
|  |  |  | EP | 2626905 A2 | 14-08-2013 |
|  |  |  | JP | 2013165197 A | 22-08-2013 |
|  |  |  | US | 2013207124 A1 | 15-08-2013 |
| DE 102010063314 | A1 | 21-06-2012 | NONE | | |
| WO 9926296 | A2 | 27-05-1999 | EP | 1029363 A2 | 23-08-2000 |
|  |  |  | EP | 2144277 A2 | 13-01-2010 |
|  |  |  | JP | 2001523895 A | 27-11-2001 |
|  |  |  | JP | 2012191229 A | 04-10-2012 |
|  |  |  | US | 6091108 A | 18-07-2000 |
|  |  |  | WO | 9926296 A2 | 27-05-1999 |

EPO FORM P0459

For more details about this annex : see Official Journal of the European Patent Office, No. 12/82